# FASCICULE DE BREVET EUROPEEN

(11) **EP 3 031 775 B1**
(45) Date de publication et mention de la délivrance du brevet: **29.03.2017**
(21) Numéro de dépôt: 15198177.6
(22) Date de dépôt: 07.12.2015
(51) Int. Cl.: B81C 1/00, H01L 23/498

(54) **PROCEDE DE REALISATION D'UNE CONNEXION ELECTRIQUE DANS UN VIA BORGNE**
VERFAHREN ZUR HERSTELLUNG EINER ELEKTRISCHEN VERBINDUNG IN EINEM SACKLOCH
METHOD FOR PRODUCING AN ELECTRICAL CONNECTION IN A BLIND VIA

(30) Priorité: 12.12.2014 FR 1462341
(43) Date de publication de la demande: 15.06.2016
(73) Titulaire: Commissariat à l'Énergie Atomique et aux Énergies Alternatives, 75015 Paris (FR)
(72) Inventeur: NICOLAS, Stéphane, 38240 Meylan (FR); FANGET, Stéphane, 38690 Le Grand Lemps (FR)
(74) Mandataire: Brevalex

(56) Documents cités:
- EP-A2- 1 022 774
- US-A- 6 137 062

## Description

### DOMAINE TECHNIQUE

La présente invention se rapporte au domaine de la microélectronique et plus particulièrement à celui de l'assemblage et de la connexion de composants électroniques par l'intermédiaire de billes fusibles et conductrices.

Elle s'applique plus particulièrement à l'assemblage et à la connexion d'un composant MEMS et/ou NEMS (MEMS pour microsystème électromécanique et NEMS pour nano-système électromécanique) avec un autre élément ou un dispositif électronique.

### ART ANTÉRIEUR

Il existe deux principales manières de connecter électriquement des composants microélectroniques entre eux : les techniques de connexions de type « wire bonding » (en français appelées « micro-câblages ») et les techniques de connexions de type « flip-chip » (en français nommées « connexion par billes »).

La technique de flip-chip consiste à relier électriquement des composants par l'intermédiaire de structures métalliques sous forme de billes disposées sur des plots d'un des composants.

Cette solution a pour avantage de mettre en oeuvre un assemblage présentant un encombrement réduit car les composants sont généralement empilés les uns au-dessus des autres.

La connexion électrique réalisée présente également de bonnes performances électriques, la longueur du contact étant notamment beaucoup plus courte que dans le cas de connexions par wire-bonding.

Le document US 8 704 368 B1 présente un assemblage entre un premier support et un deuxième support, le premier support comportant des billes conductrices fusibles disposées dans des trous de vias borgnes et qui sont ensuite reportées sur des zones de reprise de contact. L'assemblage décrit dans ce document est prévu de sorte qu'un espace entre le premier support et le deuxième support est conservé.

Le document US6 137 062 B1 présente également un assemblage entre deux supports au moyen de billes fusibles.

Avec de tels procédés on ne contrôle donc pas précisément l'écrasement des billes.

D'autre part, l'assemblage est réalisé de manière à disposer une bille sur chacun des deux supports. Si le diamètre des différentes billes n'est pas uniforme certaines billes du premier support ne seront pas en contact physique avec les billes en regard du deuxième support ce qui est susceptible de créer un contact électrique défectueux.

Par conséquent, il existe un besoin réel de réaliser un assemblage qui soit amélioré vis-à-vis d'inconvénients mentionnés ci-dessus.

### EXPOSÉ DE L'INVENTION

Selon un mode de réalisation, la présente invention concerne un procédé de réalisation d'une structure comprenant des étapes consistant à :
a) déposer une bille fusible sur une première zone conductrice située au fond d'un trou borgne formé au niveau d'une première face d'un premier support, le trou borgne étant délimité par le fond, une ou plusieurs parois latérales, ainsi qu'une embouchure, la bille fusible ayant des dimensions adaptées par rapport aux dimensions du trou borgne de sorte que la bille fusible déposée dépasse de l'embouchure du trou borgne et est située à distance des parois latérales du trou borgne,
b) assembler le premier support avec un deuxième support par report de la bille fusible sur une deuxième zone conductrice située sur une première face du deuxième support, le report étant prévu de sorte à mettre la première face du deuxième support au niveau de l'embouchure du trou borgne, le report étant effectué de manière écraser la bille fusible, la bille ayant des dimensions adaptées par rapport à celles du trou borgne de sorte qu'une fois la première face du deuxième support située au niveau de l'embouchure du trou borgne, la bille écrasée est maintenue à distance des parois latérales du trou borgne.

La présente invention permet en outre la réalisation d'une structure d'interconnexion qui a la particularité d'être compacte, la bille étant maintenue dans le trou borgne et n'induisant pas d'encombrement supplémentaire dans l'assemblage final.

Le fait de maintenir la bille à distance des parois latérales du trou borgne permet notamment de limiter les contraintes mécaniques dan l'assemblage final.

Pendant et après l'étape d'assemblage à l'étape b), lorsque le premier et le deuxième support subissent une variation de température, ils sont susceptibles de se déformer. Le fait de garder un espace vide entre les billes et les parois permet une déformation sans ou avec peu de contraintes.

Le fait de conserver un espace entre la bille et les des parois latérales du trou borgne permet également d'éviter un contact électrique entre les parois latérales et la bille conductrice.

La présente invention a également pour avantage de proposer une connexion avec moins d'étapes de fabrication et à un coût moins élevé par rapport aux technologies d'interconnexion de type TSV (acronyme de « Through Silicon Via » et TGV (acronyme de « Through Glass Via ») existantes.

Dans le procédé, la mise en contact de la première face du deuxième support au niveau de l'embouchure du trou borgne permet un contrôle de l'écrasement des billes.

L'assemblage peut être réalisé par thermocompression. Ainsi, l'assemblage peut être réalisé à une température apte à mettre au moins partiellement en fusion la bille. Par ailleurs, l'application d'une pression mécanique par exemple à l'aide d'une machine de scellement de l'un des supports sur l'autre facilite l'écrasement de la ou des billes dans le trou borgne. Chaque trou borgne peut comporter une zone conductrice ou plusieurs zones conductrices distinctes. De préférence, une seule bille étant disposée par zone conductrice. Les distances Δ et Δ' ne sont pas nécessairement constantes tout autour de la bille en particulier lorsqu'il y a plusieurs billes dans un même trou borgne.

Selon une possibilité de mise en oeuvre du procédé, le fond du trou borgne peut être recouvert partiellement de la première zone conductrice, la première zone conductrice n'étant pas en contact avec les parois latérales du trou borgne. Dans un cas notamment où les parois du trou borgne sont conductrices, on cherche à éviter un contact avec les parois.

Cet agencement peut permettre de s'assurer de garder à distance la bille conductrice des parois du trou.

Selon une possibilité de mise en oeuvre, le trou borgne peut être prévu avec au moins une paroi conductrice. L'agencement précité peut permettre de s'assurer de garder à distance la bille conductrice de la paroi conductrice du trou.

Selon une possibilité de mise en oeuvre du procédé, le premier support comporte au moins un microsystème électromécanique.

Selon une possibilité de mise en oeuvre du procédé, la première face du premier support peut comporter un capot d'encapsulation du microsystème électromécanique.

Selon une possibilité de mise en oeuvre du procédé, le deuxième support peut comprendre un circuit ASIC (acronyme de l'anglais *« Application Specific Integrated Circuit »*)*.*

Selon une possibilité de mise en oeuvre du procédé, une couche d'amortissement de contrainte peut être prévue à l'étape b) entre le premier support et le deuxième support. Ainsi, on limite l'impact de contraintes liées à la thermocompression sur l'assemblage final. On limite également la dégradation des matériaux métalliques par corrosion dû à la présence d'oxygène dans l'atmosphère en encapsulant les zones de contact avec une couche étanche aux gaz.

La couche d'amortissement est réalisée avantageusement sur le support qui présente le moins de relief ou de rugosité.

Cette couche d'amortissement de contrainte peut être formée sur le deuxième support préalablement à l'étape b).

Selon une possibilité de mise en oeuvre du procédé, après l'étape b), on peut effectuer une découpe de l'assemblage du premier et du deuxième support en plusieurs éléments.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1A-1D représentent un exemple de procédé d'assemblage entre un premier support et un deuxième support permettant l'interconnexion du premier support et deuxième support par le biais de billes conductrices ;
- les figures 2A-2B illustrent des exemples particuliers de réalisation du procédé dans lesquels une couche d'amortissement de contrainte est formée sur le premier support en vue de l'assemblage avec le deuxième support ;
- la figure 3 illustre une variante de réalisation dans laquelle la couche d'amortissement de contrainte est prévue sur le deuxième support;
- la figure 4 illustre l'assemblage entre le premier support et le deuxième support avec la couche d'amortissement intermédiaire ;
- la figure 5 illustre une étape de découpe en plusieurs éléments d'une structure formée de l'assemblage entre le premier support et le deuxième support ;
- la figure 6 illustre une variante de réalisation pour laquelle un même trou borgne comporte plusieurs billes et zones conductrices ;

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

En outre, dans la description ci-après, des termes qui dépendent de l'orientation de la structure tels que « sur », « au fond », « supérieure », s'appliquent en considérant que la structure est orientée de la façon illustrée dans les figures.

### EXPOSÉ DÉTAILLÉ DE MODES DE RÉALISATION PARTICULIERS

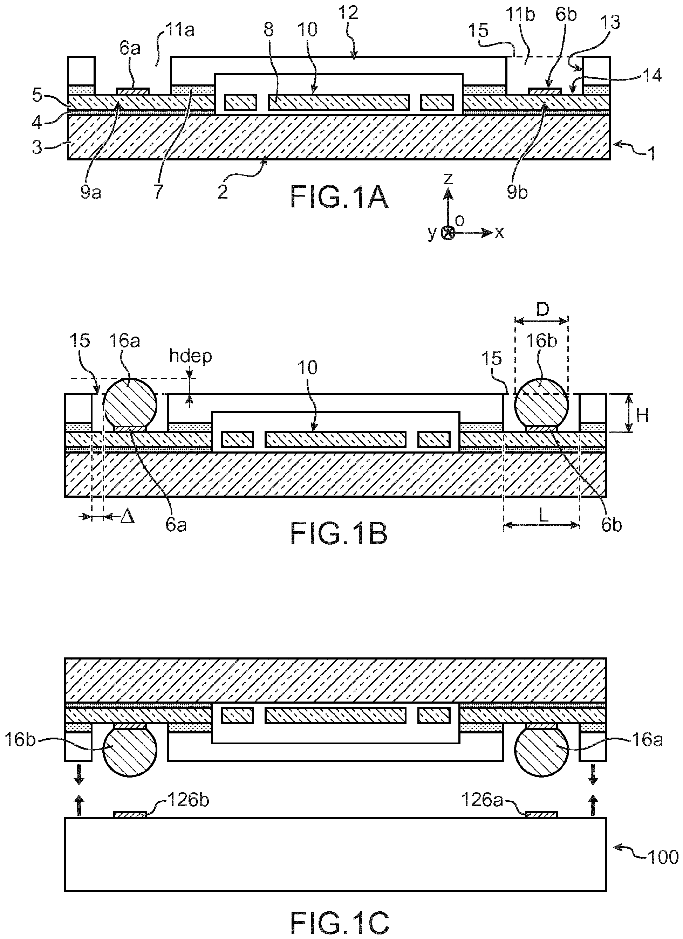

On se réfère tout d'abord à la figure 1A qui représente un premier support 1, formé d'un premier substrat 2 dans lequel un composant 10 MEMS (pour *« microsystème électromécanique »*) est réalisé.

Ce composant 10 comprend au moins une structure 8 présentant au moins un degré de liberté ainsi qu'une ou plusieurs électrodes 9a, 9b de détection de déplacement de la structure 8 et/ou d'actionnement de la structure 8 et sur lesquelles des zones conductrices 6a, 6b de reprise de contact sont respectivement disposées.

Le substrat 2 peut être semi-conducteur et par exemple en silicium.

Avantageusement, le substrat 2 est un substrat de type semi-conducteur sur isolant, par exemple de type SOI (pour « Silicon On Insulator » ou silicium sur isolant) ou Bonded SOI et comportant une couche de support 3 semi-conductrice, une couche isolante 4 disposée sur et en contact de la couche de support 3 semi-conductrice et une couche semi-conductrice 5 superficielle disposée sur et en contact de la couche isolante. Dans ce cas, la structure 8 ainsi que les électrodes 9a, 9b peuvent être au moins partiellement formées dans la couche semi-conductrice superficielle. Cette couche semi-conductrice 5 superficielle peut avoir une épaisseur inférieure à 1 µm dans le cas d'un substrat SOI ou comprise entre 1 µm et 100 µm dans le cas d'un substrat de type « Bonded SOI ».

Le premier support 1 comporte également un deuxième substrat 12 assemblé au premier substrat 2 et forme un capot recouvrant le composant MEMS 10. Le deuxième substrat 12 peut être par exemple à base de silicium ou de verre et peut être assemblé au premier substrat 1 directement ou par exemple par l'intermédiaire d'un cordon 7 de scellement qui peut être par exemple à base de polymère, de verre fritté ou d'un ou plusieurs matériau(x) métallique(s). Dans le cas d'un substrat 12 en verre et un substrat 2 en silicium, on peut procéder à l'assemblage des 2 substrats par scellement anodique. Dans le cas où les deux substrats 2 et 12 sont en silicium, on peut les assembler par collage moléculaire.

L'assemblage du deuxième substrat 12 et du premier substrat 2 forme une cavité dans laquelle la structure sensible du composant MEMS est disposée. Cette cavité peut être éventuellement fermée. Des trous borgnes 11a, 11b sont prévus dans le premier support 1 et dévoilent respectivement les zones conductrices 6a, 6b de reprise de contact. Les trous 11a, 11b peuvent traverser le deuxième substrat 12 et ont un fond 14 qui s'étend parallèlement à un plan principal du premier support 1 et dévoile les électrodes 9a, 9b. Par « plan principal » du premier support 1 on entend un plan qui passe par le premier support 1 et qui est parallèle au plan [O ; x ; y] du repère orthogonal [O ; x ; y ; z] sur la figure 1A.

Chaque zone conductrice 6a (respectivement 6b) de reprise de contact est disposée sur une région du fond 14 d'un trou borgne 11a (respectivement 11b) et recouvre partiellement ce fond 14. Les zones conductrices 6a, 6b de reprise de contact sont disposées à une distance non-nulle de parois latérales 13 du trou. Par parois latérales 13 des trous 11a, 11b on entend des parois qui s'étendent entre le fond 14 et l'embouchure 15 des trous. Les parois latérales 13 s'étendent dans une direction réalisant un angle non-nul avec le plan principal du premier support 1. Les parois latérales 13 peuvent être verticales et s'étendre comme sur l'exemple de la figure 1A parallèlement au vecteur z du repère orthogonal [O ; x; y; z]. Les zones conductrices 6a, 6b de reprise de contact peuvent être à base d'un matériau métallique à base d'un ou plusieurs des matériaux suivants : Cr, Ni, Ti, Cu, Al, Au.

A partir de la structure qui vient d'être décrite en liaison avec la figure 1A, on peut ensuite effectuer un dépôt de billes fusibles 16a, 16b à base de matériau métallique respectivement sur les zones conductrices 6a, 6b de reprise de contact (figure 1B).

Pour réaliser cette étape on peut par exemple utiliser une technique de report de billes communément appelée solder jetting ou jet de bille assistée par laser, telle que décrite par exemple dans le document « Solder Jetting - A Versatile Packaging and Assembly Technology for Hybrid Photonics and Optoelectronical Systems » IMAPS 42nd International Symposium on Microelectronics, Volume: Proceedings of the IMAPS 42nd International Symposium on Microelectronics. Une telle méthode permet de placer les billes 16a, 16b de manière précise en réalisant une soudure des billes sur les zones 6a, 6b de reprise de contact à l'aide d'un laser. Les billes 16a, 16b peuvent être par exemple à base d'un ou plusieurs matériaux métalliques choisi(s) parmi les matériaux suivants : Sn, Pb, Ag, Au, Cu, In. Les billes 16a, 16b peuvent être à base d'un alliage métallique choisi par exemple parmi des alliages suivants : SnPb, AuSn, SnAgCu, InPb, AgSn, AgSnPb, InSnPb.

Les dimensions des billes 16a, 16b sont prévues par rapport à celle des trous borgnes 11a, 11b de telle sorte que les billes 16a, 16b dépassent de l'embouchure 15 des trous borgnes 11a, 11b située dans cet exemple au niveau d'une face supérieure du premier support 1. Ainsi, lorsque les billes 16a, 16b ont une forme sphérique ou sensiblement sphérique, on peut prévoir leur diamètre D supérieur à la hauteur H des trous borgnes 11a, 11b mesurée parallèlement au vecteur z du repère orthogonal [O ; x; y ; z] sur la figure 1B. Les billes fusibles 16a, 16b peuvent avoir un diamètre D compris par exemple entre 0.05 mm et 1 mm. Les trous borgnes 11a, 11b peuvent avoir une hauteur H comprise par exemple entre 0.04 et 1 mm.

Les trous borgnes 11 peuvent également avoir une dimension critique L encore appelé diamètre L compris par exemple entre 0.06 et 1 mm. Par « dimension critique » on entend ici la plus petite dimension d'un motif hormis son épaisseur. Le diamètre L des trous est dans l'exemple de la figure 1B mesurée dans un plan [O ;x; y] du repère orthogonal [O ; x ; y ; z].

Les dimensions des billes 16a, 16b peuvent également être prévues par rapport à celles des trous 11a, 11b de telle sorte que les billes 16a, 16b sont situées à une distance Δ non nulle des parois latérales 13 des trous borgnes 11a, 11b et ne sont pas en contact avec ces parois. La distance Δ peut être comprise par exemple entre 10 et 100 µm.

Les dimensions des billes 16a, 16b peuvent également être prévues par rapport à celles des trous 11a, 11b de telle sorte que la hauteur hdep de dépassement des billes 16a, 16b mesurée entre une zone des billes située au niveau de l'embouchure des trous borgnes et le sommet des billes 16 peut être comprise par exemple entre 10 µm et 100 µm.

Une structure ainsi réalisée peut être ensuite assemblée avec un deuxième support 100 comprenant un troisième substrat doté par exemple d'un circuit électronique 110 spécialisé ASIC (figures 1C-1D).

Pour permettre un alignement précis des deux supports 1 et 100, on peut préalablement à l'assemblage utiliser un équipement de type « bond aligner qui permet d'obtenir une précision d'alignement de l'ordre du micron. L'assemblage est ensuite réalisé par thermo-compression par exemple dans un équipement de type « wafer bonder qui permet de porter la structure assemblée à une température suffisante pour permettre une fusion des billes conductrices tout en appliquant une force contrôlée, par exemple comprise entre 0.5 kN et 90 kN pour permettre une mise en compression des billes fusibles 16a, 16b sur des plots conducteurs 126a, 126b du deuxième support 100. Les plots conducteurs 126a, 126b forment des deuxièmes zones conductrices de reprise de contact. On réalise ainsi une connexion électrique entre les premières zones conductrices de reprise de contact et les deuxièmes zones de reprise de contact.

L'assemblage par thermo-compression est effectué de manière à provoquer un écrasement des billes fusibles 16a, 16b de manière à réduire leur hauteur.

Les billes fusibles 16a, 16b ont des dimensions, en particulier un diamètre D, adapté(es) par rapport aux dimensions des trous borgnes 11, en particulier leur diamètre L de sorte que lorsque les billes 16a, 16b sont au maximum de leur écrasement lors de la thermocompression elles restent situées à une distance Δ' non-nulle des parois latérales 12 des trous borgnes 11. A l'issue de l'étape de thermocompression, les billes 16a, 16b ne sont ainsi pas en contact avec les parois 12 des trous borgnes 11a, 11b. On évite ainsi que les billes appuient contre les parois 12 des trous. Dans un cas où une ou plusieurs parois latérales 12 des trous borgnes 11a, 11b sont en un matériau conducteur, on évite également un contact électrique.

La température à laquelle les billes 16a, 16b sont portées lors de la thermocompression est prévue supérieure à la température de fusion du matériau ou de l'alliage de matériaux à base duquel les billes 16a, 16b sont formées et peut être située par exemple entre 90°C et 300°C.

Par exemple, lorsque les billes fusibles 16a, 16b sont à base de SnPb, la température de fusion peut être de l'ordre de 180°C, tandis que la température de fusion peut être de l'ordre de 210°C lorsque les billes fusibles 16a, 16b sont à base de SnAgCu ou de 130°C lorsque les billes fusibles 16a, 16b sont à base d'InSnPb.

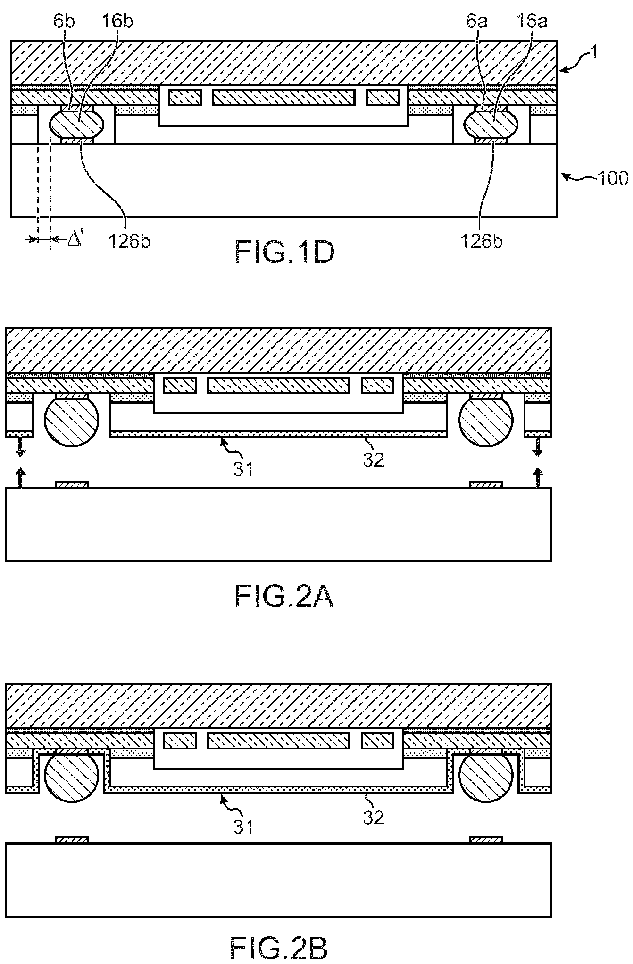

L'assemblage entre les supports 1 et 100 est en outre réalisé de sorte qu'hormis la mise en contact des billes fusibles 16a, 16b avec les plots conducteurs 126a, 126b, une face supérieure du premier support 1 est en outre disposée contre une face supérieure du deuxième support 100. Ainsi, on ne prévoit pas d'espace entre la face supérieure du premier support 1 et la face supérieure du deuxième support 100. Un matériau de remplissage appelé « d'underfill » et habituellement utilisé pour remplir un tel type d'espace n'est donc ici pas nécessaire. La face supérieure du deuxième support 100 se situe au niveau de l'embouchure 15 des trous 11a, 11b. L'assemblage des supports 1 et 100 peut être ainsi agencé de telle sorte que la face supérieure du deuxième support 100 située au niveau de l'embouchure 15 permet de fermer les trous 11a, 11b dans lesquels les billes conductrices 16a, 16b sont disposées. Dans l'exemple de la figure 1D la face supérieure du premier support 1 est au moins partiellement formée par le deuxième substrat 12.

Une variante de réalisation illustrée sur les figures 2A-2B, 3 et 4 prévoit d'introduire une couche 31 supplémentaire d'amortissement de contrainte entre le premier support 1 et le deuxième support 100.

Cette couche 31 d'amortissement de contrainte est apte à limiter d'éventuelles déformations résultant d'une dilatation différente des matériaux du premier support 1 par rapport à ceux du deuxième support 100 lors de l'étape de thermocompression. La couche 31 d'amortissement de contrainte est choisie de préférence à base d'un matériau 32 ayant un coefficient de dilatation thermique (CTE) qui est proche de celui de la face supérieure du premier support 1 et de la face supérieure du deuxième support 100 et de préférence situé entre celui de la face supérieure du premier support 1 et de la face supérieure du deuxième support 100.

Le matériau 32 peut également être choisi avec un module d'Young faible, en particulier inférieur à 1 GPa.

Le matériau 32 peut également être choisi pour sa résistance à des températures comprises par exemple entre 100°C et 200°C.

La couche 31 peut être par exemple à base de polymère tel qu'un polymère de type epoxy d'épaisseur comprise par exemple entre 10 µm et 100 µm.

Dans l'exemple de réalisation illustré sur la figure 2A, la couche 31 peut être formée sur la face du deuxième substrat comportant les trous borgnes, par exemple par laminage, avant l'assemblage avec le deuxième support 100. La couche 31 est ensuite mise en contact avec la face supérieure du deuxième support 100. On applique de préférence cette couche 31 sur le premier support 1 avant la réalisation des billes fusibles 16a, 16b. Le matériau 32 de la couche supplémentaire 31 d'amortissement de contrainte peut être un polymère photosensible que l'on structure en utilisant une technique de pholithographie.

Sur la figure 2B, la couche 31 est avantageusement formée sur la face du deuxième substrat comportant les trous borgnes 11a, 11b par exemple par laminage et photolithographie de telle sorte que la couche 31 recouvre toute la surface des trous borgnes sauf au niveau des zones 6a et 6b de reprise de contact. Lorsque la couche 31 est également à base de matériau isolant électriquement elle assure une fonction d'isolation électrique entre les billes fusibles 16a, 16b et les parois des trous borgnes.

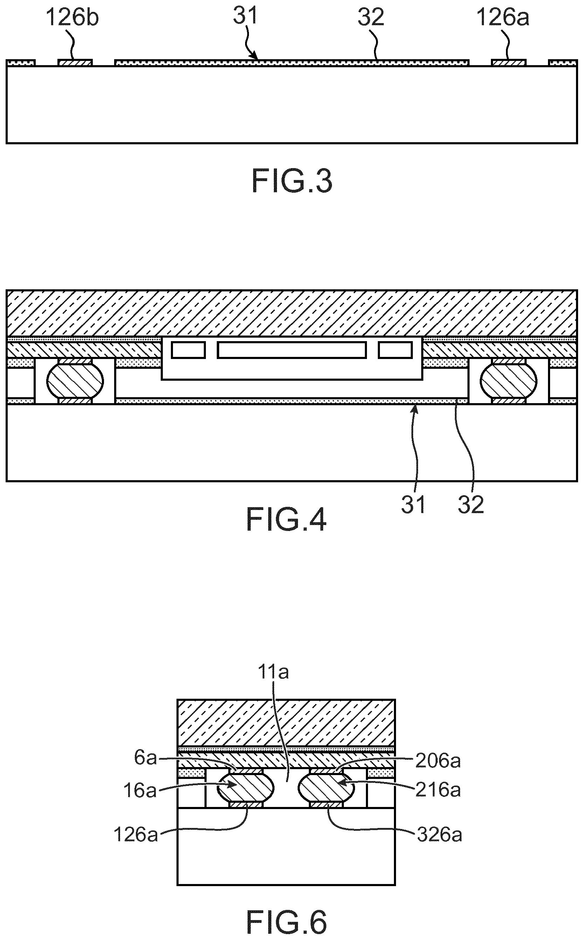

Un autre exemple de réalisation illustré sur la figure 3 prévoit avantageusement de former la couche 31 d'amortissement de contrainte sur la face du deuxième support 100 comportant les plots conducteurs 126. D'une manière générale, on peut prévoir de réaliser la couche 31d'amortissement sur le support qui présente le moins de relief ou de rugosités.

La figure 4 illustre un assemblage entre le premier support 1 et le deuxième support 100 avec la couche 31 d'amortissement de contrainte disposée entre les deux.

Dans l'un ou l'autre des exemples de procédés qui viennent d'être donnés on assemble un support de composant MEMS avec un autre support.

Le procédé peut également s'appliquer à un assemblage d'autres types d'éléments électroniques comportant des connexions électriques, par exemple un NEMS (nanosystème électromécanique), un MOEMS (microsystème opto-électromécanique), un imageur, ou encore un circuit MOS.

Le procédé peut également s'appliquer à une réalisation collective dans laquelle on assemble un premier support doté d'une pluralité de puces ou d'éléments électroniques ou de composants, avec un deuxième support doté de zones de reprise de contact.

Une fois l'assemblage réalisé, on peut alors ensuite effectuer une découpe de la structure assemblée en plusieurs éléments.

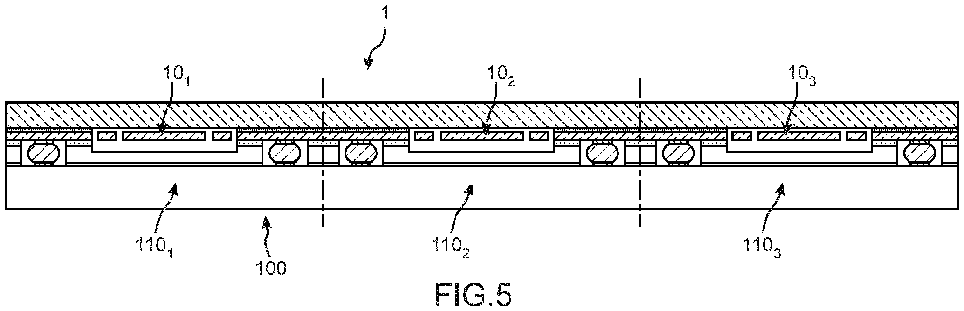

A titre d'exemple, la figure 5 illustre le premier support 1 doté de plusieurs composants MEMS 10₁, 10₂, 10₃, assemblés et connectés respectivement à des circuits électroniques 110₁, 110₂, 110₃ du deuxième support 100, ce avant de réaliser une découpe (les plans de découpe étant indiqués sur la figure 5 par l'intermédiaire de traits discontinus) de l'assemblage en plusieurs éléments, chaque élément étant doté d'un composant assemblé et connecté à un circuit électronique.

Les exemples de réalisation qui viennent d'être décrits prévoient un assemblage avec une bille conductrice par trou borgne. Le nombre de billes par trou borgne n'est pas limité.

La figure 6 illustre une variante de réalisation dans laquelle le trou borgne 11a réalisé dans le premier support 1 comporte plusieurs zones 6a, 206a de reprise de contact distinctes qui ne sont pas en contact l'une de l'autre. Chaque zone conductrice 6a, 206a disposée sur une région du fond de ce trou borgne 11a recouvre partiellement ce fond. Les zones conductrices 6a, 206a de reprise de contact sont disposées à une distance non-nulle de parois latérales du trou. Des billes fusibles 16a, 216a à base de matériau métallique sont disposées respectivement sur les zones conductrices 6a, 216a de reprise de contact. Les billes fusibles 16a, 216a peuvent également être espacées l'une par rapport à l'autre et mises en contact respectivement avec un plot conducteur 126a et un autre plot conducteur 326a du deuxième support 100.

## Revendications

1. Procédé de réalisation d'un dispositif formé d'une structure comportant un premier support (1) assemblé à un deuxième support (100), le deuxième support étant en outre connecté électriquement au premier support, le procédé comprenant des étapes consistant à :
a) déposer une bille fusible (16a, 16b) sur au moins une première zone conductrice (6a, 6b) située au fond (12) d'un trou borgne (11a, 11b) formé au niveau d'une première face d'un premier support (1), le trou borgne étant délimité par le fond (12), une ou plusieurs parois latérales (13), et une embouchure (15), la bille fusible ayant des dimensions adaptées par rapport aux dimensions du trou borgne de sorte que la bille fusible déposée dépasse de l'embouchure du trou borgne et est située à distance Δ des parois latérales (13) du trou borgne (11a, 11b),
b) assembler par thermocompression le premier support (1) avec un deuxième support (100) par report de la bille fusible (16a, 16b) sur une deuxième zone conductrice (126a, 126b) située sur une première face du deuxième support (100), le report étant prévu de sorte à mettre la première face du deuxième support (100) au niveau de l'embouchure (15) du trou borgne, le report étant en outre réalisé à une température apte à mettre au moins partiellement en fusion la bille et effectué de manière écraser la bille fusible, la bille ayant des dimensions adaptées par rapport à celles du trou borgne de sorte qu'une fois la première face du deuxième support (100) située au niveau de l'embouchure (15) du trou borgne, la bille écrasée est maintenue à distance Δ' des parois latérales du trou borgne, telle que Δ >Δ' > 0.

2. Procédé selon la revendication 1, le fond (12) du trou borgne étant recouvert partiellement de la première zone conductrice (6a, 6b), la première zone conductrice (6a, 6b) n'étant pas en contact avec les parois latérales du trou borgne.

3. Procédé selon l'une des revendications 1 ou 2, dans lequel le premier support (1) comporte au moins un MEMS et/ou NEMS.

4. Procédé selon la revendication 3, dans lequel la première face du premier support (1) comporte un capot d'encapsulation du MEMS et/ou NEMS.

5. Procédé selon l'une des revendications 1 à 4, dans le deuxième support (100) comprend au moins un dispositif choisi parmi un circuit ASIC, une carte électronique, un MEMS et/ou NEMS, une mémoire.

6. Procédé selon l'une des revendications 1 à 5, dans lequel une couche d'amortissement de contrainte est réalisée préalablement à l'étape b) sur le premier support (1) et/ou le deuxième support (100).

7. Procédé selon la revendication 6, dans lequel la couche (31) d'amortissement de contrainte est formée sur le deuxième support est réalisée préalablement à l'étape a).

8. Procédé selon l'une des revendications 1 à 7, comprenant en outre après l'étape b) au moins une étape de découpe de l'assemblage en plusieurs éléments.

9. Procédé selon l'une des revendications 1 à 8, les parois du trou borgne étant conductrices.

## Patentansprüche

1. Verfahren zum Herstellen einer Vorrichtung, welche aus einer Struktur gebildet ist, welche einen ersten Träger (1) umfasst, welcher an einem zweiten Träger (100) montiert ist, wobei der zweite Träger ferner mit dem ersten Träger elektrisch verbunden ist, wobei das Verfahren Schritte umfasst, bestehend aus:
a) Ablagern einer schmelzbaren Kugel (16a, 16b) an wenigstens einer ersten leitfähigen Zone (6a, 6b), welche am Boden (12) eines Sacklochs (11a, 11 b) angeordnet ist, welches auf dem Niveau einer ersten Fläche des ersten Trägers (1) gebildet ist, wobei das Sackloch durch den Boden (12), eine oder mehrere laterale Wände (13) und eine Öffnung (15) begrenzt ist, wobei die schmelzbare Kugel Abmessungen aufweist, welche bezüglich den Abmessungen des Sacklochs derart angepasst sind, dass die abgelagerte schmelzbare Kugel über die Öffnung des Sacklochs herausragt und in einem Abstand Δ von den lateralen Wänden (13) des Sacklochs (11 a, 11 b) angeordnet ist,
b) Verbinden des ersten Trägers (1) mit einem zweiten Träger (100) durch Thermokompression durch Verlagern der schmelzbaren Kugel (16a, 16b) in eine zweite leitfähige Zone (126a, 126b), welche an einer ersten Fläche des zweiten Trägers (100) angeordnet ist, wobei das Verlagern derart vorgesehen ist, dass die erste Fläche des zweiten Trägers (100) auf das Niveau der Öffnung (15) des Sacklochs gebracht wird, wobei das Verlagern ferner bei einer Temperatur durchgeführt wird, welche geeignet ist, die Kugel wenigstens teilweise zu schmelzen, und derart ausgeführt wird, dass die schmelzbare Kugel gequetscht wird, wobei die Kugel Abmessungen aufweist, welche bezüglich denjenigen des Sacklochs so angepasst sind, dass sobald die erste Fläche des zweiten Trägers (100) auf dem Niveau der Öffnung (15) des Sacklochs angeordnet ist, die gequetschte Kugel in einem Abstand Δ' von den lateralen Wänden des Sacklochs derart gehalten wird, dass Δ>Δ'>0.

2. Verfahren nach Anspruch 1, wobei der Boden (12) des Sacklochs teilweise durch die erste leitfähige Zone (6a, 6b) bedeckt ist, wobei die erste leitfähige Zone (6a, 6b) nicht mit den lateralen Wänden des Sacklochs in Kontakt ist.

3. Verfahren nach einem der Ansprüche 1 oder 2, wobei der erste Träger (1) wenigstens ein MEMS und/oder NEMS umfasst.

4. Verfahren nach Anspruch 3, wobei die erste Fläche des ersten Trägers (1) eine Kappe zum Verkapseln des MEMS und/oder NEMS umfasst.

5. Verfahren nach einem der Ansprüche 1 bis 4, wobei der zweite Träger (100) wenigstens eine Vorrichtung umfasst, ausgewählt aus einer ASIC-Schaltung, einer Elektronikkarte, einem MEMS und/oder einem NEMS, einem Speicher.

6. Verfahren nach einem der Ansprüche 1 bis 5, wobei eine Schicht zum Dämpfen von Spannungen vor Schritt b) auf dem ersten Träger (1) und/oder dem zweiten Träger (100) gebildet wird.

7. Verfahren nach Anspruch 6, wobei die Schicht (31) zum Dämpfen von Spannungen an dem zweiten Träger gebildet und vor dem Schritt a) hergestellt ist.

8. Verfahren nach einem der Ansprüche 1 bis 7, ferner umfassend nach Schritt b) wenigstens einen Schritt eines Schneidens der Anordnung in mehrere Elemente.

9. Verfahren nach einem der Ansprüche 1 bis 8, wobei die Wände des Sacklochs leitfähig sind.

## Claims

1. A method for making a device including a structure comprising a first support (1) assembled to a second support (100), the second support being also electrically connected to the first support, the method comprising steps consisting of:
a) depositing a meltable ball (16a, 16b) on at least a first conducting zone (6a, 6b) located at the bottom (12) of a blind hole (11a, 11b) formed on a first face of a first support (1), the blind hole being delimited by the bottom (12), one or several side walls (13), and an opening (15), the meltable ball having appropriate dimensions relative to the dimensions of the blind hole such that the deposited meltable ball projects above the opening of the blind hole and is located at a distance Δ from the side walls (13) of the blind hole (11a, 11b),
b) assembling the first support (1) with a second support (100) by thermocompression, by transferring the meltable ball (16a, 16b) onto a second conducting zone located (126a, 126b) on a first face of the second support (100), the transfer being made such that the first face of the second support (100) is located at the opening (15) of the blind hole, the transfer also being made at a temperature at which the ball can be partially melted and the meltable ball compressed, the ball having appropriate dimensions relative to the dimensions of the blind hole such that once the first face of the second support (100) is located at the opening (15) of the blind hole, the compressed ball is held at a distance Δ' from the side walls of the blind hole, such that Δ >Δ' > 0.

2. The method according to claim 1, wherein the bottom (12) of the blind hole is partially covered by the first conducting zone (6a, 6b), the first conducting zone (6a, 6b) not being in contact with the side walls of the blind hole.

3. The method according to either claim 1 or 2 wherein the first support (1) comprises at least one MEMS or NEMS.

4. The method according to claim 3, wherein the first face of the first support (1) comprises an encapsulation cap for the MEMS or NEMS.

5. The method according to any of claims 1 to 4, wherein the second support (100) comprises at least a device chosen from among an ASIC circuit, an electronic board, an MEMS, a NEMS, a memory.

6. The method according to any of claims 1 to 5, wherein a stress attenuation layer is formed before step b) on the first support (1) and/or on the second support (100).

7. The method according to claim 6, wherein the stress attenuation layer (31) is formed on the second support before step a).

8. The method according to any of claims 1 to 7, further comprising at least one step to cut the assembly into several elements after step b).

9. The method according to any of claims 1 to 8, wherein the walls of the blind hole are made of a conducting material.
